# EUROPÄISCHE PATENTSCHRIFT

(11) **EP 3 768 654 B1**
(45) Veröffentlichungstag und Bekanntmachung des Hinweises auf die Patenterteilung: **20.04.2022**
(21) Anmeldenummer: 18713175.0
(22) Anmeldetag: 20.03.2018
(51) Int. Cl.: C04B 37/02, H01L 23/373

(54) **KUPFER-KERAMIK-SUBSTRAT**
COPPER-CERAMIC SUBSTRATE
SUBSTRAT CUIVRE-CÉRAMIQUE

(43) Veröffentlichungstag der Anmeldung: 27.01.2021
(73) Patentinhaber: Aurubis Stolberg GmbH & Co. KG, 52224 Stolberg (DE)
(72) Erfinder: LEHMANN, Helge, 52393 Hürtgenwald (DE); ZEIGER, Karl, 52249 Eschweiler (DE); CAPPI, Benjamin, 4721 Neu-Moresnet (BE)
(74) Vertreter: Müller Verweyen
(86) Internationale Anmeldenummer: PCT/EP2018/056957
(87) Internationale Veröffentlichungsnummer: WO 2019/179600

(56) Entgegenhaltungen:
- EP-A1- 3 210 956
- EP-A1- 3 263 537
- WO-A1-2017/097758
- JP-B2- 5 908 473
- Anonymous: "CUC2, CU-OFE (CUC2), C10100", , 1. Januar 2018 (2018-01-01), XP055522561, Gefunden im Internet: URL:http://www.carlier.cc/fiche/31.txt [gefunden am 2018-11-09]

## Beschreibung

Die Erfindung betrifft ein Kupfer-Keramik-Substrat mit den Merkmalen des Oberbegriffs von Anspruch 1.

Kupfer-Keramik-Substrate (z.B. DCB, AMB) werden z.B. zur Herstellung von elektronischen Leistungsmodulen verwendet und sind ein Verbund aus einem Keramikträger mit entweder einseitig oder beidseitig darauf angeordneten Kupferschichten. Die Kupferschichten werden als Kupferhalbzeug in Form einer Kupferfolie üblicherweise mit einer Dicke von 0,1 bis 1,0 mm vorgefertigt und durch ein Verbindungsverfahren mit dem Keramikträger verbunden. Solche Verbindungsverfahren sind auch als DCB (Direct Copper Bonding) oder als AMB (Active Metal Brazing) bekannt. Bei einer höheren Festigkeit des Keramikträgers können jedoch auch Kupferlagen oder Kupferschichten mit einer noch größeren Dicke aufgebracht werden, was hinsichtlich der elektrischen und thermischen Eigenschaften grundsätzlich von Vorteil ist.

Als Keramikträger werden Keramikplatten z.B. aus Mullit, Al₂O₃, Si3N4, AlN, ZTA, ATZ, TiO₂, ZrO₂, MgO, CaO, CaCO₃ oder aus einer Mischung wenigstens zweier dieser Materialien verwendet.

Dabei wird die Kupferlage bei dem DCB-Verfahren durch folgende Verfahrensschritte mit der Keramikbasis verbunden:
- Oxidieren der Kupferlage derart, dass sich eine gleichmäßige Kupferoxidschicht ergibt;
- Auflegen der Kupferlage auf den Keramikträger;
- Erhitzen des Verbundes auf eine Prozesstemperatur zwischen 1060 °C und 1085 °C.

Dabei entsteht auf der Kupferlage eine eutektische Schmelze, die mit dem Keramikträger eine stoffschlüssige Verbindung eingeht. Dieser Prozess wird als Bonding bezeichnet. Sofern Al₂O₃ als Keramikträger verwendet wird, entsteht durch die Verbindung eine dünne Cu-Al-Spinellschicht.

Im Anschluss an den Bondingprozess erfolgt die Strukturierung der notwendigen Leiterbahnen durch Ätzen der zur Außenseite hin gewandten, also freien Oberfläche der Kupferlage. Anschließend werden die Chips aufgelötet und mittels Aufbringen von Bonddrähten die Verbindungen zu den Kontakten auf den Chipoberseiten hergestellt, wozu das Gefüge der freien Oberfläche der Kupferschicht möglichst homogen und fein strukturiert sein sollte. Zur Herstellung von Leistungsmodulen kann das Kupfer-Keramik-Substrat anschließend zusätzlich mit einer Bodenplatte verbunden werden.

Die Vorteile des beschriebenen Kupfer-Keramik-Substrats liegen vor allem in der hohen Stromtragfähigkeit des Kupfers und einer guten elektrischen Isolierung und mechanischen Unterstützung durch den Keramikträger. Ferner kann durch die DCB-Technologie eine hohe Haftfähigkeit der Kupferlage auf dem Keramikträger erzielt werden. Darüber hinaus sind die eingesetzten Kupfer-Keramik-Substrate beständig bei einer hohen Umgebungstemperatur, die in der Anwendung oftmals vorhanden sind.

Schwachpunkt der Kupfer-Keramik-Substrate ist die sogenannte Temperaturwechselbeständigkeit, eine Materialkenngröße, die das Versagen eines Bauteils nach einer bestimmten Anzahl von temporären thermisch induzierten Spannungen beschreibt. Dieser Parameter ist für die Lebenszeit der Leistungsmodule von Bedeutung, da sich extreme Temperaturgradienten im Betrieb der Module ergeben. Aufgrund der unterschiedlichen Wärmeausdehnungskoeffizienten von den eingesetzten Keramik- und Kupfer-Werkstoffen werden dadurch während des Einsatzes in dem Kupfer-Keramik-Substrat mechanische Spannungen thermisch induziert, was nach einer bestimmten Zyklenanzahl zu einer Delamination der Kupferschicht von der Keramikschicht und/oder zu Rissen in der Keramikschicht und/oder in der Kupferschicht und somit zu einem Versagen des Bauteils führen kann.

Grundsätzlich haben Kupfer-Keramik-Substrate mit einer Kupferschicht mit feinem Gefügen den Vorteil, dass sie Vorteile hinsichtlich der optischen Inspektion, der Bondfähigkeit, dem Ätzverhalten, der Korngrenzenausbildung, der Galvanisierbarkeit und der Weiterverarbeitung im Allgemeinen aufweisen. Nachteilig ist jedoch, dass sie aufgrund der höheren thermisch induzierten Spannungen bei Temperaturschwankungen eine geringere Lebensdauer und eine schlechtere Temperaturwechselbeständigkeit aufweisen.

Kupfer-Keramik-Substrate mit einer Kupferschicht mit gröberem Gefüge haben dagegen im Umkehrschluss den Vorteil einer höheren Lebensdauer sind aber nachteilig hinsichtlich der weiteren oben dargestellten Anforderungen.

Aus der DE 10 2015 224 464 A1 ist ein Kupfer-Keramik-Substrat bekannt, bei dem das Gefüge der Kupferschicht an der dem Keramikträger zugewandten Seite bewusst eine größere Korngröße aufweist als an der freien Oberfläche.

Der Vorteil dieser Lösung ist darin zu sehen, dass die Kupferschicht an der freien Oberfläche aufgrund der kleinere Korngröße des Gefüges leicht und sehr fein strukturiert werden kann, während die Kupferschicht auf der dem Keramikträger zugewandten Seite aufgrund der größeren Korngröße nach der Hall-Petch Beziehung eine bessere Temperaturwechselbeständigkeit aufweist. Damit kann das Kupfer-Keramik-Substrat derart verbessert werden, dass es hinsichtlich der unterschiedlichen, oben beschriebenen Anforderungen bessere Eigenschaften aufweist. Durch die gezielte Wahl der Korngrößen an den beiden Seiten der Kupferschicht wird ein neuer Auslegungsparameter geschaffen, durch welchen das Kupfer-Keramik-Substrat hinsichtlich beider Anforderungen verbessert ausgelegt werden kann.

Ein Nachteil dieser Lösung ist darin zu sehen, dass die Verwirklichung der unterschiedlichen Korngrößen einen Mehraufwand darstellt. So ist es z.B. denkbar zur Verwirklichung der unterschiedlichen Korngrößen die Kupferschicht durch Plattieren zweier unterschiedlicher Kupferschichten mit unterschiedlichen Korngrößen herzustellen, was einen zusätzlichen Arbeitsaufwand mit damit verbundenen Kosten darstellt. Dadurch wird das Kupfer-Keramiksubstrat der DE 10 2015 224 464 A1 teurer und ist damit nur für spezielle den höheren Preis rechtfertigenden Anwendungen geeignet.

Vor diesem Hintergrund liegt der Erfindung die Aufgabe zugrunde, ein Kupfer-Keramik-Substrat bereitzustellen, welches kostengünstiger herzustellen ist als das aus der Druckschrift DE 10 2015 224 464 A1 Kupfer-Keramik-Substrat und dennoch den verschiedenen Anforderungen genügt.

Erfindungsgemäß werden zur Lösung der Aufgabe ein Kupfer-Keramik-Substrat mit den Merkmalen des Oberbegriffs von Anspruch 1 vorgeschlagen. Weitere bevorzugte Weiterentwicklungen sind den Unteransprüchen zu entnehmen.

Gemäß dem Grundgedanken der Erfindung wird vorgeschlagen, dass die Kupferschicht ein Gefüge mit einem gemittelten Korngrößendurchmesser von 300 bis 500 *µ*m, bevorzugt von 300 bis 400 *µ*m, aufweist.

Dabei müssen die Körner des Gefüges nicht ausschließlich Korngrößen in den vorgeschlagenen Bereichen aufweisen, die Verteilung der Korngrößen entspricht einer monomodalen Gaußverteilung und es ist möglich, dass ein geringer Anteil der Körner auch Korngrößen von kleiner oder größer als 300 bzw. 500 *µ*m oder kleiner oder größer als 300 *µ*m bzw. 400 *µ*m aufweisen. Wichtig ist nur, dass der Mittelwert der Korngrößen innerhalb der vorgeschlagenen Bereiche liegt. Der Korngrößendurchmesser kann dabei z.B. nach dem Linienschnittverfahren ermittelt werden, welches in der ASTM 112-13 beschrieben ist. Körner mit Korngrößen von größer als 1000 *µ*m müssen aber auf jeden Fall vermieden werden.

Das vorgeschlagene Gefüge der Kupferschicht kann entweder direkt während des Bondens auf dem Keramikträger z.B. durch die Einhaltung von vorbestimmten Durchlauf- oder Verweilzeiten und die Wahl der Temperatur in dem Vorlauf und Nachlauf des Bondprozesses oder auch durch eine separate Temperaturnachbehandlung verwirklicht werden.

Der Vorteil des vorgeschlagenen Kupfer-Keramik-Substrats ist darin zu sehen, dass es eine hinreichend hohe Lebensdauer aufweist, da durch Wahl des gemittelten Korngrößendurchmesser die Körner eine gemittelte Größe aufweisen, durch welche nach der Hall-Petch Beziehung ein ausreichend niedriges Spannungsniveau in dem Substrat während der unter den normalen Verwendungen auftretenden temperaturbedingten Biegewechselbeanspruchung verwirklicht werden kann, um die gewünschte hohe Lebensdauer zu erzielen. Außerdem können die Anforderungen an die Bondbarkeit, die optische Inspektion, das zur Einbringung der Leiterstruktur erforderliche Ätz- oder Schneidverfahren und weitere spezifische Anforderungen erfüllt werden, wozu eine mittlere Korngröße von kleiner als 500 *µ*m oder besonders bevorzugt von kleiner als 400 *µ*m von Vorteil ist.

Um diese vorteilhaften Gefügeeigenschaften der Kupferschicht nach dem Temperaturbehandlungsprozess zu erzielen, wird weiter vorgeschlagen, dass
- die Kupferschicht
- wenigstens 99,95 % Cu, bevorzugt wenigstens 99,99 % Cu aufweist.

Ferner kann die Kupferschicht bevorzugt einen Anteil von
- maximal 25 ppm Ag aufweisen.

Gemäß einer weiteren bevorzugten Ausführungsform kann die Kupferschicht einen Anteil von
- maximal 10 ppm, bevorzugt max 5 ppm O aufweisen.

Weiter wird vorgeschlagen, dass
- die Kupferschicht einen Anteil der Elemente Cd, Ce, Ge, V, Zn von jeweils maximal 0-1 ppm aufweist, wobei
- die Kupferschicht gemäß einer weiteren bevorzugten Ausführungsform einen Anteil der Elemente Cd, Ce, Ge, V, Zn von insgesamt mindestens 0,5 ppm und maximal 5 ppm aufweist.

Weiter wird vorgeschlagen, dass
- die Kupferschicht einen Anteil der Elemente Bi, Se, Sn, Te von jeweils maximal 0-2 ppm aufweist, wobei
- die Kupferschicht gemäß einer weiteren bevorzugten Ausführungsform einen Anteil der Elemente Bi, Se, Sn, Te von insgesamt mindestens 1,0 ppm und maximal 8 ppm aufweist.

Weiter wird vorgeschlagen, dass
- die Kupferschicht einen Anteil der Elemente Al, Sb, Ti, Zr von jeweils maximal 0-3 ppm aufweist, wobei
- die Kupferschicht gemäß einer weiteren bevorzugten Ausführungsform einen Anteil der Elemente Al, Sb, Ti, Zr von insgesamt mindestens 1,0 ppm und maximal 10 ppm aufweist.

Weiter wird vorgeschlagen, dass
- die Kupferschicht einen Anteil der Elemente As, Co, In, Mn, Pb, Si von jeweils maximal 0-5 ppm aufweist, wobei
- die Kupferschicht gemäß einer weiteren bevorzugten Ausführungsform einen Anteil der Elemente As, Co, In, Mn, Pb, Si von insgesamt mindestens 1,0 ppm und maximal 20 ppm aufweist.

Weiter wird vorgeschlagen, dass
- die Kupferschicht einen Anteil der Elemente B, Be, Cr, Fe, Mn, Ni, P, S von jeweils maximal 0-10 ppm aufweist, wobei
- die Kupferschicht gemäß einer weiteren bevorzugten Ausführungsform einen Anteil der Elemente B, Be, Cr, Fe, Mn, Ni, P, S von insgesamt mindestens 1,0 ppm und maximal 50 ppm aufweist.

Weiter wird vorgeschlagen, dass
- die Kupferschicht einen Anteil der in den Ansprüchen 4 bis 16 genannten Elemente einschließlich weiterer Verunreinigungen von bevorzugt maximal 50 ppm aufweist.

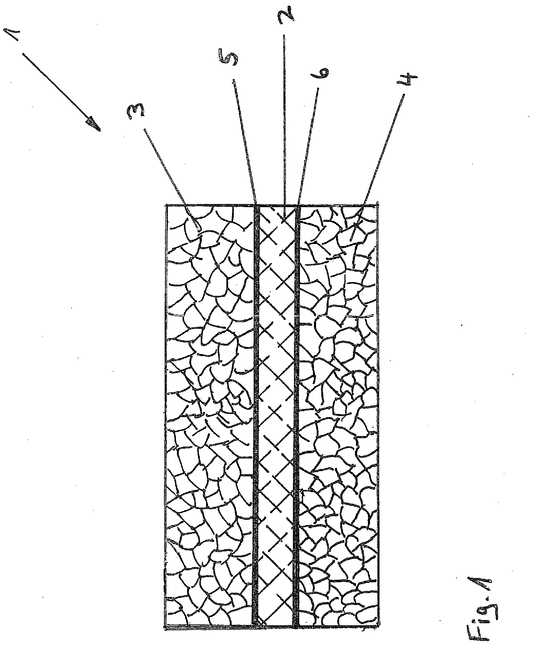

Die Erfindung wird im Folgenden anhand bevorzugter Ausführungsformen unter Bezugnahme auf die beigefügten Figuren erläutert. Dabei zeigt
- Fig. 1: ein erfindungsgemäßen Kupfer-Keramik-Substrat mit zwei Kupferschichten

Leistungsmodule sind Halbleiterbauelemente der Leistungselektronik und werden als Halbleiterschalter eingesetzt. Sie enthalten in einem Gehäuse mehrere vom Kühlkörper elektrisch isolierte Leistungshalbleiter (Chips). Diese werden auf eine metallisierte Oberfläche einer elektrisch isolierenden Platte (z.B. aus Keramik) mittels Löten oder Kleben aufgebracht, damit einerseits die Wärmeabgabe in Richtung Bodenplatte, andererseits aber auch die elektrische Isolierung gewährleistet ist. Der Verbund aus metallisierten Schichten und isolierender Platte wird als Kupfer-Keramik-Substrat bezeichnet und wird großtechnisch über die sogenannte DCB-Technologie (Direct Copper Bonding) realisiert.

Die Kontaktierung der Chips wird durch Bonden mit dünnen Bonddrähten realisiert. Darüber hinaus können weitere Baugruppen unterschiedlichster Funktion (z.B. Sensoren, Widerstände) vorhanden und integriert sein.

Zur Herstellung eines DCB-Substrates werden Keramikträger (z.B. Al₂O₃, Si3N4, AIN, ZTA, ATZ) ober- und unterseitig mit Kupferlagen in einem Bondprozess miteinander verbunden. In Vorbereitung auf diesen Prozess können die Kupferlagen vor dem Auflegen auf den Keramikträger oberflächlich oxidiert (z.B. chemisch oder thermisch) und anschließend auf den Keramikträger aufgelegt werden. Die Verbindung entsteht in einem Hochtemperaturprozess zwischen 1060 °C und 1085 °C, wobei auf der Oberfläche der Kupferlage eine eutektische Schmelze entsteht, die mit dem Keramikträger eine Verbindung eingeht. Diese Verbindung besteht beispielsweise im Falle von Kupfer (Cu) auf Aluminiumoxid (Al₂O₃) aus einer dünnen Cu-Al-Spinellschicht.

In der Fig. 1 ist ein erfindungsgemäß weiterentwickeltes Kupfer-Keramik-Substrat 1 mit einem Keramikträger 2 und zwei Kupferschichten 3 und 4 zu erkennen. Die beiden erfindungsgemäß weiterentwickelten Kupferschichten 3 und 4 weisen erfindungsgemäß ein Gefüge mit einem mittleren Korngrößendurchmesser von 200 bis 500 *µ*m, bevorzugt von 300 bis 400 *µ*m, auf.

Die Kupferschichten 3 und 4 können z.B. nach dem eingangs beschriebenen DCB-Verfahren mit dem Keramikträger 2 verbunden sein, so dass diese durch eine stoffschlüssige Verbindung in den jeweiligen Oberflächenrandzonen 5 und 6 mit dem Keramikträger 2 verbunden sind.

Während des DCB-Verfahrens werden die Kupferschichten 3 und 4 in Form von voroxidierten Kupferhalbzeugen auf den Keramikträger 2 aufgelegt und dann auf die Prozesstemperatur von 1060 °C bis 1085 °C erhitzt. Dabei schmilzt das Cu-Oxydul in den Kupferschichten 3 und 4 und bildet die Verbindungen in den Oberflächenrandzonen mit dem Keramikträger 2 aus. Aufgrund der Temperatureinwirkung und der Rekristallisation der beiden Kupferwerkstoffe kann das Gefüge durch die Wahl entsprechender Verweilzeiten und Abkühlzeiten so eingestellt werden, dass sich der bevorzugte mittlere Korngrößendurchmesser selbsttätig einstellt. Da dem Fachmann der Einfluss der Temperaturbehandlung einschließlich des Abkühlprozesses ohne weiteres bekannt sind, kann er die Parameter gezielt so wählen, dass sich das Gefüge erfindungsgemäß ausbildet, ohne dass eine weitere Temperaturbehandlung erforderlich ist. Sofern der Bondprozess eine derartige Einstellung nicht zulässt oder dies aus wirtschaftlichen Gründen nachteilig ist, kann das Gefüge aber auch durch eine nachfolgende oder vorher durchgeführte Temperaturbehandlung erzielt werden. Ferner weisen die Kupferschichten 3 und 4 nach dem Bonden bevorzugt eine Vickershärte von 40 bis 100 auf.

Die Kupferschichten 3 und 4 mit dem erfindungsgemäßen Gefüge bzw. mit den erfindungsgemäß vorgeschlagenen Anteilen und insbesondere mit den vorgeschlagenen O-Anteilen sind hochleitfähige Cu-Werkstoffe und weisen eine Leitfähigkeit von 50 MS/m bevorzugt mindestens 57 MS/m und besonders bevorzugt von mindestens 58 MS/m auf. Es sind jedoch auch Werkstoffe mit einer niedrigeren Leitfähigkeit denkbar.

Die Kupferhalbzeuge der Kupferschichten 3 und 4 können eine Dicke von 0,1 bis 1,0 mm aufweisen und werden in großen Abmaßen auf den Keramikträger 2 aufgelegt und durch das DCB-Verfahren mit dem Keramikträger 2 verbunden. Anschließend wird das großflächige Kupfer-Keramik-Substrat 1 in kleinere Einheiten geschnitten und weiterverarbeitet.

Die Kupferschichten 3 und 4 können ferner wenigstens 99,95 % Cu, bevorzugt wenigstens 99,99 % Cu, maximal 25 ppm Ag, maximal 10 ppm bzw. bevorzugt maximal 5 ppm O. aufweisen. Zusätzlich können die Kupferschichten 3 und 4 einen Anteil der Elemente Cd, Ce, Ge, V, Zn von jeweils maximal 0-1 ppm aufweisen und/oder einen Anteil der Elemente Bi, Se, Sn, Te von jeweils maximal 0-2 ppm aufweisen und/oder einen Anteil der Elemente Al, Sb, Ti, Zr von jeweils maximal 0-3 ppm aufweisen und/oder einen Anteil der Elemente As, Co, In, Mn, Pb, Si von jeweils maximal 0-5 ppm aufweisen und/oder einen Anteil der Elemente B, Be, Cr, Fe, Mn, Ni, P, S von jeweils maximal 0-10 ppm aufweisen. Die aufgezählten zusätzlichen Elemente können durch Dotierung während des Schmelzprozesses unmittelbar vor dem Gießen bewusst in das Gefüge eingebracht sein oder auch aufgrund von Verunreinigungen bereits bei der Herstellung der Kupferhalbzeuge in den Kupferschichten 3 und 4 vorhanden sein. Jedenfalls sollte der Anteil dieser Elemente einschließlich weiterer Verunreinigungen bevorzugt maximal 50 ppm betragen.

Weiter kann die Kupferschicht gemäß einer weiteren bevorzugten Ausführungsform einen Anteil der Elemente Cd, Ce, Ge, V, Zn von insgesamt mindestens 0,5 ppm und maximal 5 ppm, einen Anteil der Elemente Bi, Se, Sn, Te von insgesamt mindestens 1,0 ppm und maximal 8 ppm, einen Anteil der Elemente Al, Sb, Ti, Zr von insgesamt mindestens 1,0 ppm und maximal 10 ppm einen Anteil der Elemente As, Co, In, Mn, Pb, Si von insgesamt mindestens 1,0 ppm und maximal 20 ppm und einen Anteil der Elemente B, Be, Cr, Fe, Mn, Ni, P, S von insgesamt mindestens 1,0 ppm und maximal 50 ppm aufweisen.

Die beschriebenen Mengenanteile der Elemente sind notwendig, um die erfindungsgemäß vorgeschlagene mittlere Korngröße des Gefüges zu erzielen. Dabei ist die Gefügeausbildung insbesondere auf die durch die Elemente bewirkte Kornfeinung des Gefüges und auf die Verminderung der Sekundärrekristallisation in dem Gefüge beim Bondprozess zurückzuführen. Zum Beispiel kann durch das Element As die Rekristallisationstemperatur geändert und insbesondere erhöht werden, so dass sich das Gefüge während des Bondprozesses nicht mehr soweit verändert, dass die mittlere Korngröße vergrößert wird und damit außerhalb des vorgeschlagenen Bereiches gelangt. Ferner kann durch das Element Zr die Beibehaltung des Gefüges mit einem Erhalt der mittleren Korngröße bei einer Temperatureinwirkung bewirkt werden, da das Zr als Fremdkeim wirkt.

## Patentansprüche

1. Kupfer-Keramik-Substrat (1) mit
- einem Keramikträger (2), und
- mindestens einer mit einer Oberfläche des Keramikträgers (2) verbundenen Kupferschicht (3,4), welche
- eine freie Oberfläche zur Ausbildung einer Leiterstruktur und/oder zur Befestigung von Bonddrähten aufweist, **dadurch gekennzeichnet, dass**
- die Kupferschicht (3,4) ein Gefüge mit einem gemittelten Korngrößendurchmesser von 300 bis 500 *µ*m, aufweist, und
- die Kupferschicht (3,4) einen Anteil von wenigstens 99,95 % Cu, bevorzugt wenigstens 99,99 % Cu aufweist,
- die Kupferschicht (3,4) einen Anteil der Elemente B, Be, Cr, Fe, Mn, Ni, P, S von jeweils maximal 0-10 ppm aufweist, wobei
- die Kupferschicht (3,4) einen Anteil der Elemente B, Be, Cr, Fe, Mn, Ni , P, S von insgesamt mindestens 1,0 ppm und maximal 50 ppm aufweist.

2. Kupfer-Keramik-Substrat (1) nach Anspruch 1, **dadurch gekennzeichnet, dass**
- die Kupferschicht (3,4) eine elektrische Leitfähigkeit von mindestens 50 MS/m, bevorzugt von mindestens 57 MS/m und besonders bevorzugt von mindestens 58 MS/m aufweist.

3. Kupfer-Keramik-Substrat (1) nach Anspruch 1 oder 2, **dadurch gekennzeichnet, dass**
- die Kupferschicht (3,4) eine Härte nach Vickers von 40 bis 100 aufweist.

4. Kupfer-Keramik-Substrat (1) nach einem der vorangegangenen Ansprüche, **dadurch gekennzeichnet, dass**
- die Kupferschicht (3,4) einen Anteil von maximal 25 ppm Ag aufweist.

5. Kupfer-Keramik-Substrat (1) nach einem der vorangegangenen Ansprüche, **dadurch gekennzeichnet, dass**
- die Kupferschicht (3,4) einen Anteil von maximal 10 ppm, bevorzugt maximal 5 ppm O aufweist.

6. Kupfer-Keramik-Substrat (1) nach einem der vorangegangenen Ansprüche, **dadurch gekennzeichnet, dass**
- die Kupferschicht (3,4) einen Anteil der Elemente Cd, Ce, Ge, V, Zn von jeweils maximal 0-1 ppm aufweist.

7. Kupfer-Keramik-Substrat (1) nach Anspruch 6, **dadurch gekennzeichnet, dass**
- die Kupferschicht (3,4) einen Anteil der Elemente Cd, Ce, Ge, V, Zn von insgesamt mindestens 0,5 ppm und maximal 5 ppm aufweist.

8. Kupfer-Keramik-Substrat (1) nach einem der vorangegangenen Ansprüche, **dadurch gekennzeichnet, dass**
- die Kupferschicht (3,4) einen Anteil der Elemente Bi, Se, Sn, Te von jeweils maximal 0-2 ppm aufweist.

9. Kupfer-Keramik-Substrat (1) nach Anspruch 8, **dadurch gekennzeichnet, dass**
- die Kupferschicht (3,4) einen Anteil der Elemente Bi, Se, Sn, Te von insgesamt mindestens 1,0 ppm und maximal 8 ppm aufweist.

10. Kupfer-Keramik-Substrat (1) nach einem der vorangegangenen Ansprüche, **dadurch gekennzeichnet, dass**
- die Kupferschicht (3,4) einen Anteil der Elemente Al, Sb, Ti, Zr von jeweils maximal 0-3 ppm aufweist.

11. Kupfer-Keramik-Substrat (1) nach Anspruch 10, **dadurch gekennzeichnet, dass**
- die Kupferschicht (3,4) einen Anteil der Elemente Al, Sb, Ti, Zr von insgesamt mindestens 1,0 ppm und maximal 10 ppm aufweist.

12. Kupfer-Keramik-Substrat (1) nach einem der vorangegangenen Ansprüche, **dadurch gekennzeichnet, dass**
- die Kupferschicht (3,4) einen Anteil der Elemente As, Co, In, Mn, Pb, Si von jeweils maximal 0-5 ppm aufweist.

13. Kupfer-Keramik-Substrat (1) nach Anspruch 12, **dadurch gekennzeichnet, dass**
- die Kupferschicht (3,4) einen Anteil der Elemente As, Co, In, Mn, Pb, Si von insgesamt mindestens 1,0 ppm und maximal 20 ppm aufweist.

14. Kupfer-Keramik-Substrat (1) nach einem der vorangegangenen Ansprüche, **dadurch gekennzeichnet, dass**
- die Kupferschicht (3,4) einen Anteil der in den Ansprüchen 6 bis 13 genannten Elemente einschließlich weiterer Verunreinigungen von maximal 50 ppm aufweist.

## Claims

1. Copper-ceramic substrate (1) comprising
- a ceramic carrier (2), and
- at least one copper layer (3, 4) bonded to a surface of the ceramic carrier (2), which has a
- free surface for forming a conductor structure and/or for securing bonding wires,
**characterised in that**
- the copper layer (3, 4) has a microstructure with an average grain size diameter of 300 to 500 *µ*m, and
- the copper layer (3, 4) has a proportion of at least 99.95% Cu, preferably at least 99.99% Cu,
- the copper layer (3, 4) has a proportion of the elements B, Be, Cr, Fe, Mn, Ni, P, S of, in each case, at most 0-10 ppm, wherein
- the copper layer (3, 4) has a proportion of the elements B, Be, Cr, Fe, Mn, Ni, P, S of a total of at least 1.0 ppm and at most of 50 ppm.

2. Copper-ceramic substrate (1) according to claim 1, **characterised in that**
- the copper layer (3, 4) has an electrical conductivity of at least 50 MS/m, preferably of at least 57 MS/m and particularly preferably of at least 58 MS/m.

3. Copper-ceramic substrate (1) according to claim 1 or 2, **characterised in that**
- the copper layer (3, 4) has a Vickers hardness of 40 to 100.

4. Copper-ceramic substrate (1) according to any one of the preceding claims, **characterised in that**
- the copper layer (3, 4) has a proportion of at most 25 ppm Ag.

5. Copper-ceramic substrate (1) according to any one of the preceding claims, **characterised in that**
- the copper layer (3, 4) has a proportion of at most 10 ppm, preferably at most 5 ppm of O.

6. Copper-ceramic substrate (1) according to any one of the - preceding claims, **characterised in that**
- the copper layer (3, 4) has a proportion of the elements Cd, Ce, Ge, V, Zn of, in each case, at most 0-1 ppm.

7. Copper-ceramic substrate (1) according to claim 6, **characterised in that**
- the copper layer (3, 4) has a proportion of the elements Cd, Ce, Ge, V, Zn of a total of at least 0.5 ppm and at most 5 ppm.

8. Copper-ceramic substrate (1) according to any one of the preceding claims, **characterised in that**
- the copper layer (3, 4) has a proportion of the elements Bi, Se, Sn, Te of, in each case, at most 0-2 ppm.

9. Copper-ceramic substrate (1) according to claim 8, **characterised in that**
- the copper layer (3, 4) has a proportion of the elements Bi, Se, Sn, Te of a total of at least 1.0 ppm and at most 8 ppm.

10. Copper-ceramic substrate (1) according to any one of the preceding claims, **characterised in that**
- the copper layer (3, 4) has a proportion of the elements Al, Sb, Ti, Zr of, in each case, at most 0-3 ppm.

11. Copper-ceramic substrate (1) according to claim 10, **characterised in that**
- the copper layer (3, 4) has a proportion of the elements Al, Sb, Ti, Zr of a total of at least 1.0 ppm and at most 10 ppm.

12. Copper-ceramic substrate (1) according to any one of the preceding claims, **characterised in that**
- the copper layer (3, 4) has a proportion of the elements As, Co, In, Mn, Pb, Si of, in each case, at most 0-5 ppm.

13. Copper-ceramic substrate (1) according to claim 12, **characterised in that**
the copper layer (3, 4) has a proportion of the elements As, Co, In, Mn, Pb, Si of a total of at least 1.0 ppm and at most 20 ppm.

14. Copper-ceramic substrate (1) according to any one of the preceding claims, **characterised in that**
- the copper layer (3, 4) has a proportion of the elements mentioned in claims 6 to 13, including further impurities, of at most 50 ppm.

## Revendications

1. Substrat cuivre-céramique (1) pourvu
- d'un support en céramique (2), et
- d'au moins une couche de cuivre (3, 4) reliée avec une surface du support en céramique (2), laquelle présente
- une surface libre permettant la formation d'une structure conductrice et/ou permettant la fixation de fils de connexion,
**caractérisé en ce que**
- la couche de cuivre (3, 4) présente une structure avec un diamètre de taille particulaire moyen de 300 à 500 µm, et
- la couche de cuivre (3, 4) présente une proportion d'au moins 99,95 % de Cu, de préférence, d'au moins 99,99 % de Cu,
- la couche de cuivre (3, 4) présente une proportion en éléments B, Be, Cr, Fe, Mn, Ni, P, S, respectivement d'au maximum 0 à 10 ppm, dans lequel
- la couche de cuivre (3, 4) présente une proportion des éléments B, Be, Cr, Fe, Mn, Ni, P, S au total d'au moins 1,0 ppm et d'au maximum 50 ppm.

2. Substrat cuivre-céramique (1) selon la revendication 1, **caractérisé en ce que**
- la couche de cuivre (3, 4) présente une conductivité électrique d'au moins 50 MS/m, de préférence, d'au moins 57 MS/m et, de manière particulièrement préférée, d'au moins 58 MS/m.

3. Substrat cuivre-céramique (1) selon la revendication 1 ou la revendication 2, **caractérisé en ce que**
- la couche de cuivre (3, 4) présente une dureté selon Vickers de 40 à 100.

4. Substrat cuivre-céramique (1) selon l'une des revendications précédentes, **caractérisé en ce que**
- la couche de cuivre (3, 4) présente une proportion d'au maximum 25 ppm d'Ag.

5. Substrat cuivre-céramique (1) selon l'une des revendications précédentes, **caractérisé en ce que**
- la couche de cuivre (3, 4) présente une proportion d'au maximum 10 ppm, de préférence, d'au maximum 5 ppm d'O.

6. Substrat cuivre-céramique (1) selon l'une des revendications précédentes, **caractérisé en ce que**
- la couche de cuivre (3, 4) présente une proportion des éléments Cd, Ce, Ge, V, Zn, respectivement, d'au maximum 0 à 1 ppm.

7. Substrat cuivre-céramique (1) selon la revendication 6, **caractérisé en ce que**
- la couche de cuivre (3, 4) présente une proportion des éléments Cd, Ce, Ge, V, Zn au total d'au moins 0,5 ppm et d'au maximum 5 ppm.

8. Substrat cuivre-céramique (1) selon l'une des revendications précédentes, **caractérisé en ce que**
- la couche de cuivre (3, 4) présente une proportion des éléments Bi, Se, Sn, Te, respectivement, d'au maximum 0 à 2 ppm.

9. Substrat cuivre-céramique (1) selon la revendication 8, **caractérisé en ce que**
- la couche de cuivre (3, 4) présente une proportion des éléments Bi, Se, Sn, Te au total d'au moins 1,0 ppm et d'au maximum 8 ppm.

10. Substrat cuivre-céramique (1) selon l'une des revendications précédentes, **caractérisé en ce que**
- la couche de cuivre (3, 4) présente une proportion des éléments Al, Sb, Ti, Zr, respectivement, d'au maximum de 0 à 3 ppm.

11. Substrat cuivre-céramique (1) selon la revendication 10, **caractérisé en ce que**
- la couche de cuivre (3, 4) présente une proportion des éléments Al, Sb, Ti, Zr au total d'au moins 1,0 ppm et d'au maximum 10 ppm.

12. Substrat cuivre-céramique (1) selon l'une des revendications précédentes, **caractérisé en ce que**
- la couche de cuivre (3, 4) présente une proportion des éléments As, Co, In, Mn, Pb, Si, respectivement, d'au maximum 0 à 5 ppm.

13. Substrat cuivre-céramique (1) selon la revendication 12, **caractérisé en ce que**
- la couche de cuivre (3, 4) présente une proportion des éléments As, Co, In, Mn, Pb, Si au total d'au moins 1,0 ppm et d'au maximum 20 ppm.

14. Substrat cuivre-céramique (1) selon l'une des revendications précédentes, **caractérisé en ce que**
- la couche de cuivre (3, 4) présente une proportion d'autres impuretés en plus des éléments cités dans les revendications 6 à 13 d'au maximum 50 ppm.
